# EUROPEAN PATENT APPLICATION

(11) **EP 3 916 572 A1**
(43) Date of publication of application: **01.12.2021**
(21) Application number: 20176694.6
(22) Date of filing: 27.05.2020
(51) Int. Cl.: G06F 13/40, B64D 45/00, G07C 5/08, H05K 5/02, G06K 13/08, G06F 1/18

(54) **DIGITAL DATA RECORDER**

(71) Applicant: SDT UZAY ve Savunma Teknolojileri AS, Ankara (TR)
(72) Inventor: Yildirmoglu, Gurol, ANKARA (TR)
(74) Representative: Kayahan, Senem

(57) **Abstract**

The invention relates to a digital data recorder system with a removable memory module.

## Description

### TECHNICAL FIELD

The subject of the invention relates to a digital data recorder system with a removable memory module.

### PRIOR ART

Most naval, land and air platforms (aircraft, ships, etc.) have digital data recorders (DDR), where mission data (navigation, sound, image, etc.) is recorded. The collected data is then transferred to the main computers to be processed. Transfer of data from the DDRs to main computers is performed by removable memory modules (RMM). The platform user, (pilot, captain, etc.) places an empty RMM in the corresponding slot on the DDR before the mission. During the mission, all the data is saved to the RMM and after the mission, RMM is removed and taken to the operation centres to transfer the data to the main computers. The DDR systems are mostly produced to be used in military platforms and therefore have the requirement of electromagnetic and liquid impermeability. To provide this, the RMM has a lid that completely covers the respective slot after it is installed.

The data exchange between the removable memory module (RMM) and the digital data recorder (DDR) is established via connector, one side of which is behind the RMM and its corresponding part is in the DDR, located on a stationary electronic board at the bottom of the RMM slot. When the RMM is inserted in the slot, these connectors correspond mutually; and pushing further, connectors will mate and establish the necessary connection. Then, the cover of the RMM slot is closed and the DDR becomes impermeable. As the RMM stays too deep inside after it is placed in the slot, it is ergonomically difficult to grip, pull and remove it (especially with the gloves used by pilots). In some DDRs, when the cover of the slot is opened, a special mechanism pulls out the RMM a little from its slot, which makes it easier to grip the RMM. But pulling the RMM from its place also detaches the data connector and interrupts the communication with the digital data recorder (DDR) which results in potential data losses.

Another problem encountered in the previous systems is that the covers generally protrude out of the DDR in the open position and occupy space in the narrow cockpit area due to opening by rotating from a single hinge axis.

### SUMMARY OF THE INVENTION

The present invention relates to a digital data recorder system with a removable memory module that eliminates the above-mentioned disadvantages.

In this invention, when the cover of the RMM slot on the digital data recorder (DDR) is opened, the removable memory module (RMM) is pushed out by the springs inside and the RMM is brought to a position that can be easily held. However, during this process, the RMM's communication with the DDR is not interrupted and the DDR is informed that the cover has been opened.

Moreover, the cover of the RMM slot opens and closes by a special door mechanism, not by rotating from a single hinge axis, but moving on small hinges which are rotating on two different axes. When the cover is in opened or closed position, it does not protrude outside the DDR and does not occupy any space.

### Definitions of the Elements/Parts/Pieces That Make Up the Invention

In order to better explain the digital data recorder, the pieces/parts/elements developed by the present invention, are individually numbered and the definition of each number is given below.
1 Digital data recorder (DDR)
2 Cover
3 Removable memory module (RMM)
4 Electronic Board
5 Push-Button Electronic Switch
6 Spring Housing
7 Connector
8 Hinge

### BRIEF DESCRIPTION OF THE FIGURES

The figures prepared for a better understanding of the digital data recorder are described below.
Figure 1 - Digital data recorder (DDR) General View
Figure 2 - Digital data recorder (DDR) and Removable memory module (RMM) General View
Figure 3 - Removable memory module Compartment (RMM Cover Closed)
Figure 4 - Removable memory module Compartment (RMM Cover Open)
Figure 5 - Digital data recorder (DDR) Double Hinge System

### DETAILED DESCRIPTION OF THE INVENTION

In this detailed description, the novelty of the invention is explained only with examples for a better understanding of the subject without any limiting effect. The present invention relates to a digital data recorder system with a removable memory module.

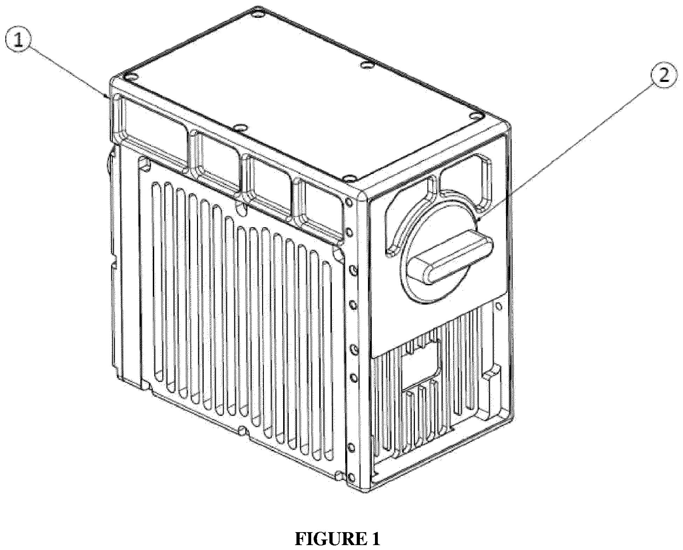

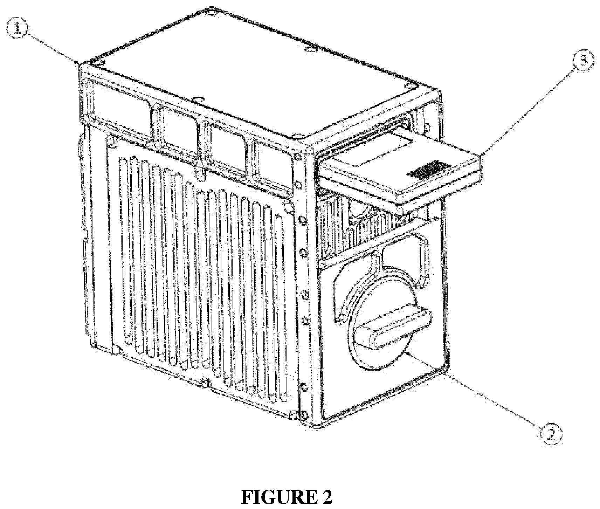

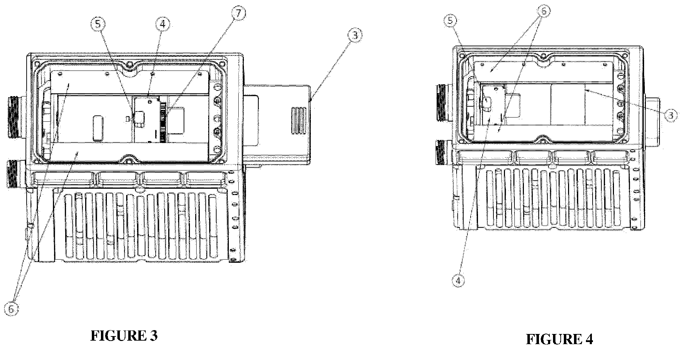

In the existing systems, the part of the connector that is on the DDR (1) side which enables data exchange between the digital data recorder (DDR) (1) and the removable memory module (RMM) (3) is fixed on the DDR (1). The most important feature of the present invention is that this connector can be moved back and forth with the electronic board to which it is connected. This electronic board (4) (Figure 3) is pushed outward using the springs located inside the spring housings (6) (Figure 3) in the DDR (1). After the RMM (3) is placed in its slot, it is pushed to the bottom part by applying force against the springs while closing the cover thereon. After reaching the bottom, since the electronic board (4) and the connector (7) lean on the back wall of the DDR, applying some more force mates the connectors (7) (Figure 3) on the DDR (1) and the RMM (3). Meanwhile, the RMM cover (2) (Figures 1 and 2) is also closed and the cover becomes locked. At the same time, the push-button switch (5) (Figure 3) on the electronic board (4) switches from the "open" position to the "closed" position as it leans on the back wall of the digital data recorder (DDR). In this way, the information that the cover (2) is closed is transmitted to the digital data recorder (DDR) (1). The positions of the electronic board (4) and the RMM (3) in the digital data recorder (DDR) (1) are shown in Figure 3 and Figure 4 when the RMM cover (2) is open and closed respectively.

When the RMM cover (2) is opened, the springs push the electronic board (4) with the connector (7) that provides data exchange and the RMM (3). In this way, a large part of the RMM (3) projects out of the DDR (1) so that it can be easily gripped by hand. Meanwhile, since the electronic board (4) is pushed out together with the RMM (3), the connector connection between the RMM (3) and the DDR (1) is not disconnected yet, however since the push-button electronic switch has not been pushed to the bottom anymore, it is switched from the "closed" position to the "open" position. In this way, the DDR (1) will be informed that the RMM cover (2) is opened and so, the DDR (1) stops data exchange with the RMM (3). After this, the user safely pulls the RMM (3) out.

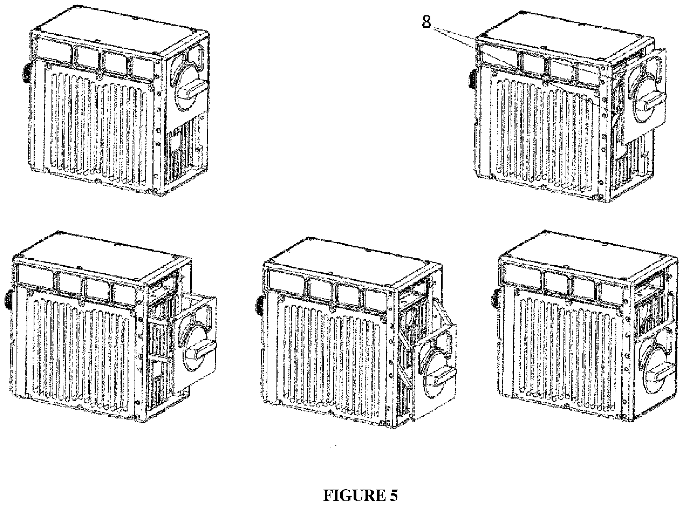

Another feature of the present invention is the double-hinged (8) cover (2) system (Figure 5). In this system, the cover (2) does not move by rotating from the axis of a single hinge (8), instead, it (2) moves parallel to the body as shown in Figure 5. In this way, the cover does not form a protrusion out of the body in the "open" and "closed" positions and does not occupy space. Another advantage of this movement system is that the cover and the RMM (3) are always in contact with each other at a right angle when the cover (2) pushes the RMM (3) inwards and thereby prevents the RMM (3) from getting stuck in the slot while moving inwards.

The present invention is a digital data recorder comprising;
- A removable memory module (RMM) (3) that enables the information recorded by the digital data recorder (DDR) (1) to be taken from the digital data recorder (DDR) and taken to the data processing centres,
- A removable memory module (RMM) cover (2) that closes the removable memory module slot inlet on the digital data recorder (DDR) (1),
- An electronic board (4) movable back and forth, provided with a connector (7) that enables data exchange between the removable memory module (RMM) (3) and the digital data recorder (DDR) (1),
- A push-button electronic switch (5), which informs the digital data recorder (DDR) (1) whether the cover (2) of the removable memory module (RMM) (3) slot is open or closed according to the position it is in,
- At least one movable connector (7) for data exchange between the digital data recorder (DDR) (1) and the removable memory module (RMM) (3),
- At least one spring housing (6) in which the springs pushing the electronic board (4) inside the digital data recorder (DDR) (1) are placed,
- At least one hinge (8) that enables the cover to move in parallel with the digital data recorder (DDR) (1).

Operating method of the digital data recorder based on the detailed explanations above characterized by comprising the process steps of;
- Pushing the electronic board (4) (Figure 3) to which the connector (7) is connected outward using the springs located inside the spring housings (6) (Figure 3) in the digital data recorder (DDR) (1),
- After the removable memory module (RMM) (3) is placed in its slot, pushing it to the bottom part by applying force against the springs while closing the cover (2) on the removable memory module,
- When the bottom part is reached, since the electronic board (4) and the connector (7) lean on the back wall of the digital data recorder (DDR) (1), pushing the RMM forward to ensure that the connectors (7) (Figure 3) on the digital data recorder (DDR) (1) and the removable memory module (RMM) (3) are mated,
- Meanwhile, closing the removable memory module cover (2) (Figure 1 and Figure 2) and locking the removable memory module cover (2),
- At the same time, switching of the push-button switch (5) (Figure 3) on the electronic board (4) from the "open" position to the "closed" position as it leans on the back wall of the digital data recorder (DDR) (1),
- By switching to the closed position, informing the digital data recorder (DDR) (1) that the removable memory module cover (2) is closed,
- Pushing outward the removable memory module (RMM) (3) and the electronic board (4) with the connector (7) that provides data exchange by the springs, when the removable memory module (RMM) cover (2) is opened
- Enabling the removable memory module (RMM) (3) to protrude out of the digital data recorder (DDR) (1) so that it can easily be gripped by hand,
- Ensuring that the connector (7) connection between the digital data recorder (DDR) (1) and the removable memory module (RMM) (3) are not disconnected yet since the electronic board (4) with the connector (7) is also pushed out together with the removable memory module (RMM) (3),
- Switching of the push button switch (5) from the "closed" position to the "open" position, since it is no longer pushed to the bottom
- Informing the digital data recorder (DDR) (1) that the removable memory module cover (2) is opened,
- Stopping the data exchange of the removable memory module (RMM) (3) with the digital data recorder (DDR) (1),
- Pulling out of the removable memory module (RMM) (3) safely by the user

The preferred embodiment of the invention is that said electronic board (4) and the connector (7) is movable back and forth.

Another preferred embodiment of the invention is that the said removable memory module cover (2) is movable.

Another preferred embodiment of the invention is that the movement of the said removable memory module cover (2) is parallel to the body.

Another preferred embodiment of the invention is that the said movable removable memory module cover (2) is hinged.

Another preferred embodiment of the invention is that the said hinges (8) are at least a pair.

Another preferred embodiment of the invention is that the cover (2) and the removable memory modules (RMM) (3) are always in contact perpendicular with each other as the said removable memory module cover (2) pushes the removable memory module (RMM) (3) inward while it is being closed.

## Claims

1. A digital data recorder **characterized by** comprising;
• A removable memory module (RMM) (3) that enables the data recorded by the digital data recorder (DDR) (1) to be taken from the digital data recorder (DDR) and delivered to the data processing centres,
• A removable memory module (RMM) cover (2) that closes the removable memory module slot inlet on the digital data recorder (DDR) (1),
• A movable electronic board (4), where a connector (7) that enables data exchange between the removable memory module (RMM) (3) and the digital data recorder (DDR) (1) is located,
• A push button switch (5), that informs the digital data recorder (DDR) (1) whether the cover of the removable memory module (RMM) (3) is open or closed according to the position it is in,
• At least one movable connector (7) for data exchange between the digital data recorder (DDR) (1) and the removable memory module (RMM) (3),
• At least one spring housing (6) in which the springs pushing the electronic board (4) moving back and forth inside the digital data recorder (DDR) (1) are placed,
• At least one hinge (8) that enables the cover to move parallel with the digital data recorder (DDR) (1).

2. Operating method of the digital data recorder **characterized by** comprising the process steps of;
• Pushing the electronic board (4) outward, on which the connector (7) is located, using the springs located inside the spring housings (6) in the digital data recorder (DDR) (1),
• After the removable memory module (RMM) (3) is placed in its slot, pushing it to the bottom part by applying force against the springs while closing the cover (2) on the removable memory module,
• When the bottom part is reached, since the electronic board (4) and the connector (7) lean on the back wall of the digital data recorder (DDR) (1), ensuring that some more force is applied and the connectors (7) on the digital data recorder (DDR) (1) and the removable memory module (RMM) (3) are interlocked,
• Meanwhile, closing the removable memory module cover (2) and locking the removable memory module cover (2),
• At the same time, switching of the push-button switch (5) on the electronic board (4) from the "open" position to the "closed" position as it leans on the back wall of the digital data recorder (DDR) (1),
• By switching to the closed position, informing the digital data recorder (DDR) (1), that the removable memory module cover (2) is closed
• When the removable memory module (RMM) cover (2) is opened, pushing outward of the removable memory module (RMM) (3) and the electronic board (4) with the connector (7) that provides data exchange by the springs.
• In this way, a large part of the removable memory module (RMM) (3) protrudes out of digital data recorder (DDR) (1) so that it can be easily gripped by hand,
• Ensuring that the connector (7) connection between the digital data recorder (DDR) (1) and the removable memory module (PPM) (3) are not disconnected yet since the electronic board (4) with the connector (7) is also pushed out together with the removable memory module (RMM) (3),
• Switching of the electronic push button switch (5) from "closed" position to "open" position, since it is no longer pushed to the bottom,
• Informing the digital data recorder (DDR) (1) that the removable memory module cover (2) is opened,
• Stopping the data exchange of the removable memory module (RMM) (3) with the digital data recorder (DDR) (1),
• Pulling out of the removable memory module (RMM) (3) safely by the user.

3. A digital data recorder according to Claim 1, **characterized in that** said electronic switch (5) is a push-button.

4. The digital data recorder according to Claim 1, **characterized in that** said electronic board (4) and the connector (7) is movable back and forth.

5. A digital data recorder according to Claim 1, **characterized in that** said removable memory module cover (2) is movable.

6. A digital data recorder according to Claim 1, **characterized in that** said removable memory module cover (2) is movable parallel to the body.

7. A digital data recorder according to Claim 1, **characterized in that** said movable removable memory module cover (2) is hinged.

8. A digital data recorder according to Claim 7, **characterized in that** said hinges (8) are at least a pair.

9. A digital data recorder according to Claim 1, **characterized in that** said cover (2) and the removable memory module (RMM) (3) are always in contact with each other at a right angle.
